**Europäisches Patentamt**

**European Patent Office**

**Office européen des brevets**

(19)

(11) Publication number : **0 308 612 B1**

(12) # EUROPEAN PATENT SPECIFICATION

(45) Date of publication of patent specification :
12.10.94 Bulletin 94/41

(51) Int. Cl.$^5$ : **H01L 29/78, H01L 29/08**

(21) Application number : **88111722.0**

(22) Date of filing : **20.07.88**

(54) **Field effect transistor and manufacturing method thereof.**

(30) Priority : **24.09.87 JP 241839/87**
**24.09.87 JP 241840/87**
**24.09.87 JP 241841/87**
**24.09.87 JP 241838/87**

(43) Date of publication of application :
**29.03.89 Bulletin 89/13**

(45) Publication of the grant of the patent :
**12.10.94 Bulletin 94/41**

(84) Designated Contracting States :
**DE FR GB**

(56) References cited :
**EP-A- 0 118 921**
**WO-A-82/02981**
**PATENT ABSTRACTS OF JAPAN, vol. 6, no.**
**254 (E-148)(1132), 14 December 1982; &**
**JP-A-57 153 469**
**PATENT ABSTRACTS OF JAPAN, vol. 5, no.**
**121 (E-68)(793), 5 August 1981; JP-A-56 58 267**
**PATENT ABSTRACTS OF JAPAN, vol. 8, no.**
**198 (E-265)(1635), 11 September 1984; &**
**JP-A-59 84 474**

(73) Proprietor : **MITSUBISHI DENKI KABUSHIKI**
**KAISHA**
**2-3, Marunouchi 2-chome**
**Chiyoda-ku**
**Tokyo (JP)**

(72) Inventor : **Hagino, Hiroyasu c/o Mitsubishi**
**Denki K.K.**
**Kitaitami Seisakusho**
**1, Mizuhara 4-chome**
**Itami-shi Hyogo (JP)**
Inventor : **Yamaguchi, Hiroshi c/o Mitsubishi**
**Denki K.K.**
**Kitaitami Seisakusho**
**1, Mizuhara 4-chome**
**Itami-shi Hyogo (JP)**

(74) Representative : **MEISSNER, BOLTE &**
**PARTNER**
**Patentanwälte**
**Postfach 86 06 24**
**D-81633 München (DE)**

EP 0 308 612 B1

## Description

BACKGROUND OF THE INVENTION

Field of the Invention

The present invention relates to a field effect transistor and, more particularly, to an improvement of a trade-off between the ON resistance and the breakdown voltage of a field effect transistor.

Description of the Background Art

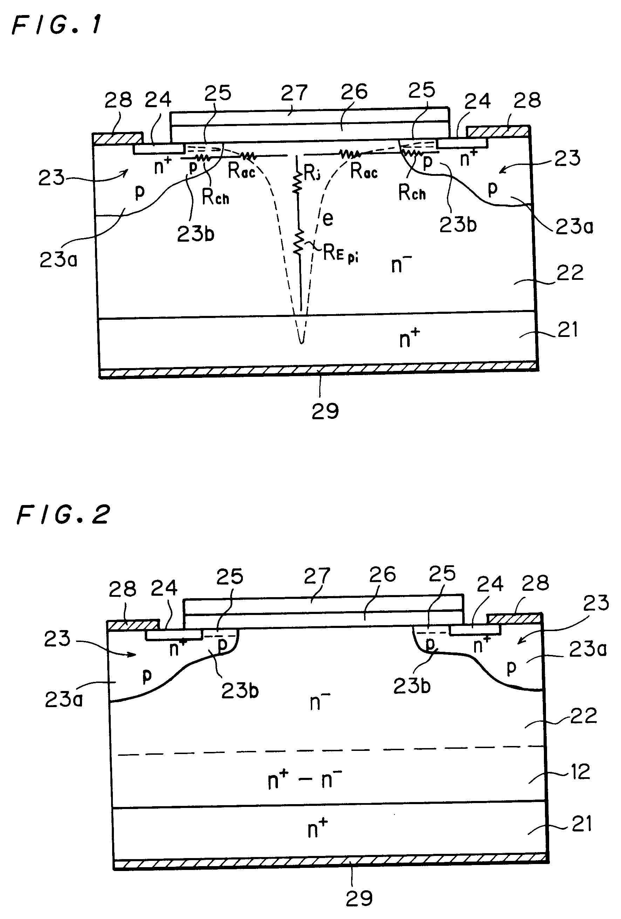

Fig. 1 is a cross sectional view typically showing a conventional vertical double diffusion type power MOS field effect transistor. Referring to Fig. 1, the field effect transistor has an $n^+$ type semiconductor substrate 21 which is doped with impurities having a relatively low diffusion coefficient, such as Sb, in a diffusion concentration of approximately $10^{19}$ atom/cm³. An $n^-$ type epitaxial layer 22 is epitaxially grown on the $n^+$ type substrate 21. The specific resistance and the thickness of the n type epitaxial layer 22 is selected in accordance with the breakdown voltage of the field effect transistor. To obtain a breakdown voltage of 500 V, for example, a specific resistance of approximately 25 $\Omega$-cm and a thickness of approximately 45 $\mu$m are required.

P type base layers 23 are partially formed in the main surface of the $n^-$ type epitaxial layer 22, and $n^+$ type source layers 24 are partially formed in the surface of the respective p type base layers 23. The p type base layers 23 comprise a first region 23a, which is formed through a relatively deep diffusion step for preventing the latch-up of a parasitic transistor formed by the $n^+$ type source layer 24, the p type base layer 23 and the n type epitaxial layer 22, as well as a second region 23b which is formed through a relatively shallow diffusion step for forming a channel region 25.

A gate insulation film 26 is formed both on the surfaces of the channel region 25 and the $n^-$ type epitaxial layer 22, and a gate electrode 27 is provided on the gate insulation film 26. Source electrodes 28 are formed on and electrically connected with both the first region 23a of the p type base layer 23 and the $n^+$ type source layer 24. A common drain electrode 29 is formed on the back surface of the $n^+$ type substrate 21.

In the power MOS field effect transistor as described above, when the source electrode 28 is grounded and the gate and drain electrodes 27 and 29 are supplied with positive voltages, the channel regions 25 in the p type base layers 23 are inverted into n type, and electrons flow from the $n^+$ type source layers 24 to the drain electrode 29 through the inverted channel regions 25 and the $n^-$ type epitaxial layer 22. Thus, the field effect transistor enters into its ON state.

In the ON state, the approximate ON resistance $R_{on}$ of the field effect transistor is represented by the following equation:

$$R_{on} = R_{ch} + R_{ac} + R_j + R_{Epi}$$

where

$R_{ch}$ : the resistance of the channel region 25

$R_{ac}$ : the accumulation resistance in the surface of the $n^-$ type epitaxial layer 22

$R_j$ : the resistance of the portion of the $n^-$ type epitaxial layer 22 between the p type base layers 23 due to the JFET effect (junction-FET effect)

$R_{Epi}$ : the resistance of the $n^-$ type epitaxial layer 22.

The resistances $R_{oh}$ and $R_{ac}$ can be reduced by fining unit cells of the MOS field effect transistor and increasing the channel width per unit area. The resistance $R_j$ can also be reduced by appropriately widening the interval between the p type base layers 23. The resistance $R_{Epi}$ is, however, generally increased when the desired breakdown voltage of the MOS field effect transistor is increased. Thus, this resistance $R_{Epi}$ is mainly responsible for the large amount of the ON resistance $R_{on}$, in the case of the MOS field effect transistor having a high breakdown voltage. For example, the ratio $R_{Epi}/R_{on}$ becomes approximately 0.8 and 0.9 for breakdown voltages of 500 V and 1000 V, respectively. Therefore, the important aspect for any improvement in the characteristics of a MOS field effect transistor having such a high breakdown voltage is how to reduce the resistance $R_{Epi}$.

The publication Patent Abstracts of Japan, vol. 6, no. 254 corresponding to the publication JP-A 57-153469 discloses a field effect transistor wherein a low resistance layer is provided adjacent to a drain electrode. The low resistance layer has an impurity density higher than a drain layer at the channel side immediately under a gate electrode and through which carrier passes.

The International Publication WO 82/02981 discloses a MOS power resistor having high breakdown voltage and reduced on-state resistance. High breakdown voltage is achieved by fabricating the device in a high resistivity epitaxial layer having a doping level consistent with the desired breakdown voltage. Reduced on-state resistance is provided by locally reducing the resistivity of the epitaxial layer in surface regions between two adjacent source regions.

The European Patent Application EP-A 0 118 921 discloses a field effect transistor device, formed so that the drain region has a low resistivity portion between the well regions and the high resistivity portion is in contact with the bottom of the well regions.

It will be noted from the above description that a conventional power MOS field effect transistor has the disadvantage that the ON loss thereof is increased as the desired breakdown voltage is increased, since the ON resistance in the $n^-$ type epitaxial layer 22 defining the breakdown voltage is increased.

Accordingly, it is an object of the present invention to provide a field effect transistor of a relatively low ON resistance and a relatively high breakdown voltage, and a manufacturing method thereof.

## SUMMARY OF THE INVENTION

A field effect transistor and a method of producing same are provided according to the present invention as defined in the claims. The present transistor comprises a first conductivity type semiconductor substrate of a relatively high first impurity concentration, having first and second major surfaces, a first conductivity type intermediate semiconductor layer formed above said first major surface of said semiconductor substrate, a first conductivity type first semiconductor layer of a relatively low second impurity concentration, a second conductivity type base layer formed in a surface of said first semiconductor layer, a first conductivity type source layer formed in a surface of said base layer, a gate insulation film formed on a surface part between said source layer and said first semiconductor layer of said base layer, a gate electrode formed on said gate insulation film, a source electrode formed on and electrically connected with said base and source layers,and a drain electrode formed on and electrically connected to said second major surface of said semiconductor substrate. Further features will be discussed below.

The present invention has the advantage that the first semiconductor layer of a relatively high specific resistance can be reduced in thickness, so that the ON resistance of the field effect transistor can be reduced, by virtue of the intermediate semiconductor layer which has a relatively low mean specific resistance. Further, the electric field of a depletion layer is eased by virtue of the gentle impurity concentration distribution of the intermediate layer, so that the breakdown voltage of the field effect transistor is not decreased in spite of a decrease in thickness of the first semiconductor layer.

These and other features, aspects and advantages of the present invention will become more apparent from the following detailed description of the present invention when taken in conjunction with the accompanying drawings.

## BRIEF DESCRIPTION OF THE DRAWINGS

Fig. 1 is a cross-sectional view showing a conventional power MOS field effect transistor; and

Fig. 2 to Fig. 5 are cross-sectional views showing constructions of a power MOS field effect transistor.

Fig. 2 is a cross-sectional view showing a construction of a field effect transistor for means of comparison. Referring to Fig. 2, this field effect transistor comprises an $n^+$ type semiconductor substrate 21 which has a relatively high impurity concentration. The $n^+$ type substrate 21 is provided thereon with a spreading layer 12 and an $n^-$ type epitaxial layer 22 which has a relatively low impurity concentration. In the spreading layer 12, the impurity concentration gradually varies such that the portion near the $n^+$ type substrate 21 has a relatively high impurity concentration while the portion near the $n^-$ type epitaxial layer 22 has a relatively low impurity concentration.

P type base layers 23 are partially formed in the main surface of the $n^-$ type epitaxial layer 22, and $n^+$ type source layers 24 are partially formed in the surface of the respective p type base layers 23. The p type base layers 23 comprise a first region 23a which is relatively deep for preventing the latch-up of a parasitic transistor formed by the $n^+$ type source layer 24, the p type base layer 23 and the $n^-$ type epitaxial layer 22, and a relatively shallow second region 23b for a channel region 25. A gate insulation film 26 is formed both on the surfaces of the channel region 25 and the $n^-$ type epitaxial layer 22, and the gate electrode 27 is provided on the gate insulation film 26. Source electrodes 28 are formed on and electrically connected to both the first region 23a of the p type base layer 23 and the $n^+$ type source layer 24. A common drain electrode 29 is provided on the back surface of the $n^+$ type substrate 21.

The manufacturing method of the comparative MOS field effect transistor illustrated in Fig. 2 will now be described. First, the $n^+$ type substrate 21 having a relatively high impurity concentration is prepared by doping into a semiconductor substrate n type impurities having a relatively large diffusion coefficient such as phosphorus, in a concentration of approximately $10^{19}$ to $10^{20}$ atom/cm$^3$. Then, the $n^-$ type epitaxial layer 22, which

is 50 μm in thickness and has a relatively high specific resistance of approximately 25 to 30 Ω-cm, is epitaxially grown on the n+ type substrate 21. Thereafter, the n+ type substrate 21 is spreaded into the n‾ type epitaxial layer 22 by approximately 25 μm by heat treatment, to form the spreading layer 12. Namely, n type impurities in the substrate 21 are diffused into the n‾ type epitaxial layer 22, in the heat treatment, to provide a gentle impurity concentration distribution in the spreading layer 12 between the n+ type substrate 21 and the n‾ type epitaxial layer 22.

Then, the first regions 23a of the p type base layers 23 of approximately 5 to 10 μm in depth are selectively formed in the main surface of the n‾ type epitaxial layer 22 by an ion implantation method,a selective diffusion method or the like. Thereafter, the gate insulation film 26 and a patterned polysilicon layer serving as the gate electrode 27 are formed in sequence on the n‾ type epitaxial layer 22. Then, p type impurities are doped into the n‾ type epitaxial layer 22 by using the polysilicon layer as a mask, to form the second regions 23b of the p type base layers 23. Since the second regions 23b form the channel region 25, the impurity concentration and the diffusion depth of the second regions 23b must be selected in accordance with the threshold voltage of the field effect transistor. In general, the impurity concentration may be approximately $5 \times 10^{13}$ to $5 \times 10^{14}$ $cm^{-3}$ and the depth may be approximately 4 to 6 μm.

Then, the n+ type source layers 24 of approximately 0.5 to 1 μm in depth are selectively formed in the surface of the p type base layers 23 by double diffusion technique by using the polysilicon layer as a mask. The surface impurity concentration of the n+ type source layers 24 may be approximately $3 \times 10^{20}$ atom/$cm^3$. Thus, the surface portions of the second regions 23b between the n+ type source layers 24 and the n‾ type epitaxial layer 22 form the channel regions 25. In general, the length of the respective channel regions 25 may be approximately 3 to 5 μm, in the MOS field effect transistor of a high breakdown voltage,

Then, the source electrodes 28, which are electrically connected to the p type base layer 23 and the n+ type source layer 24, are formed on these layers 23 and 24, and the common drain electrode 29, which is electrically connected to the n+ type substrate 21, is formed on the back surface of the substrate 21. Thus, the power MOS field effect transistor of the structure illustrated in Fig. 2 is completed.

The power MOS field effect transistor of this comparison device has a relatively thin (e.g., approximately 25 μm in the above embodiment) n‾ type epitaxial layer 22, in comparison with the epitaxial layer of a conventional device, which is approximately 45 μm in thickness as hereinbefore described. Thus, the thickness of the n‾ type epitaxial layer 22 having a relatively large specific resistance is about half of that in the prior art, and hence the resistance $R_{Epi}$ can be greatly reduced. Although this embodiment device has the spreading layer 12 of approximately 25 μm in thickness instead, the mean specific resistance of the spreading layer 12 is smaller than one tenth of the specific resistance of the n‾ type epitaxial layer 22. In other words, the resistance of the spreading layer 12 is substantially the same as that of the n‾ type epitaxial layer 22 of approximately 4 μm in thickness. Therefore, the resistance $R_{Epi}$ scarcely depends on the resistance of the spreading layer 12. As a result, the ON resistance due to the n‾ type epitaxial layer 22 and the spreading layer 12 in this embodiment can be reduced to an amount of only about 30 percent of the ON resistance due to the n‾ type epitaxial layer 22 in a comparable conventional device.

Thus, the total ON resistance $R_{on}$ of the power MOS field effect transistor can be reduced to the extent of about 35 to 40 percent of that of a conventional one.

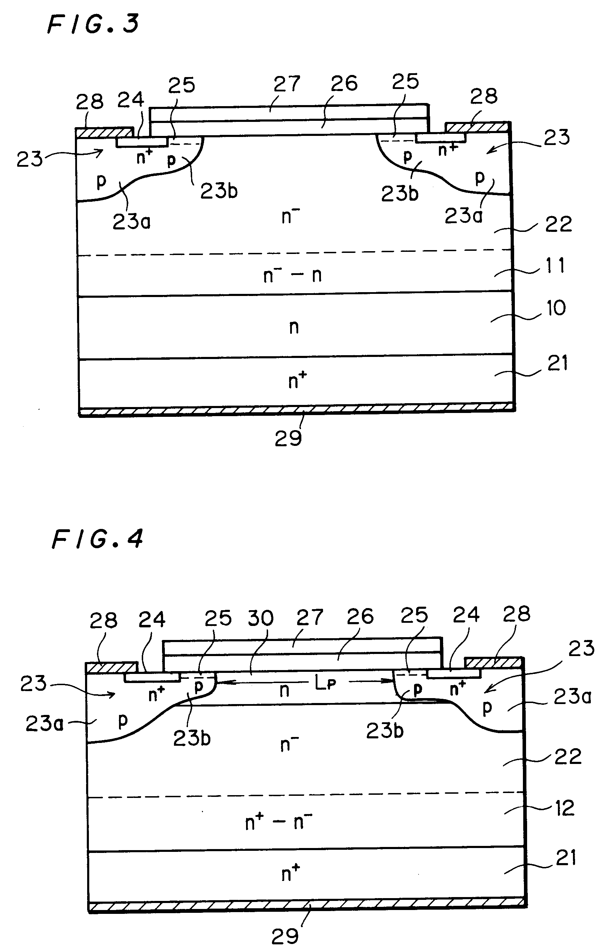

Fig. 3 is a cross-sectional view showing a second construction of a power MOS field effect transistor. Referring to Fig. 3, this power MOS field effect transistor comprises an n type buffer layer 10 in addition to the layers of the embodiment device shown in Fig. 2. The buffer layer 10 is interposed between an n+ type semiconductor substrate 21 and a spreading layer 11. Other structures are the same as those in the first construction shown in Fig. 2.

In fabrication of the second construction device, first the n type buffer layer 10 is epitaxially grown on the n+ type substrate 21. The n+ type substrate 21 is prepared by, for example, doping into a silicon substrate n type impurities, which have a relatively low diffusion coefficient, such as antimony (Sb), in a concentration of approximately $10^{19}$ atom/$cm^3$. The n type buffer layer 10 may be approximately 20 μm in thickness and doped with n type impurities having a relatively large diffusion coefficient, such as phosphorus, and a specific resistance of about 0.05 to 0.5 Ω-cm.

Then, the n type buffer layer 10 is provided thereon with an n‾ type epitaxial layer 22, which is approximately 20 μm in thickness and has a relatively high specific resistance of approximately 30 Ω-cm, by epitaxial growth. Thereafter, the n type buffer layer 10 is spreaded into the n‾ type epitaxial layer 22 to some extent by heat treatment, to form the spreading layer 11. Namely, n type impurities in the buffer layer 10 are diffused into the n‾ type epitaxial layer 22, in the heat treatment, to provide a gentle impurity concentration distribution in the spreading layer 11. Besides the n type buffer layer (10) has a middle impurity concentration of those of the n+ type substrate 21 and the n‾ type epitaxial layer 22. Thus, a moderate impurity concentration distribution is implemented between the n+ type substrate 21 and the n‾ type epitaxial layer 22. Other procedures are the same as those in the above described first construction shown in Fig. 2.

In this second construction, the thickness of the $n^-$ type epitaxial layer 22 is approximately 15 $\mu$m, which is smaller than half of that in the prior art, and the mean specific resistance of the n type buffer layer 10 and the spreading layer 11 is lower than one tenth of that of the $n^-$ type epitaxial layer 22, similar to the first construction. Therefore, the total ON resistance $R_{on}$ of the power MOS field effect transistor according to the second embodiment can also be reduced to the extent of about 35 to 40 percent of that of a conventional device.

Fig. 4 is a cross-sectional view showing a third construction of a power MOS field effect transistor. Referring to Fig. 4, an n type semiconductor layer 30 is provided in the surface of the $n^-$ type epitaxial layer 22, between the p type base layers 23. Other structures are the same as those in the first construction shown in Fig. 2.

In fabrication of the third construction device, the n type semiconductor layer 30, which has a relatively low specific resistance, is formed between first regions 23a of the p type base layers 23, in the surface of the $n^-$ type epitaxial layer 22, by using an ion implantation method, a selective diffusion method or the like, after completion of forming the first regions 23a of the p type base layers 23. Alternatively, the n type semiconductor layer 30 may be formed on the surface of the $n^-$ type epitaxial layer 22 by using an epitaxial growth method, an ion implantation method, a selective diffusion method or the like, before forming the first regions 23a of the p type base layers 23. Other procedures are the same as those in the above described first construction shown in Fig. 2.

The power MOS field effect transistor according to the third construction has the following advantages in addition to those of the first construction shown in Fig. 1. Namely, the JFET effect caused between the p type base layers 23 is weakened by virtue of the n type semiconductor layer 30 of a relatively low specific resistance, which is formed between the p type base layers 23 in place of the $n^-$ type epitaxial layer 22 of a relatively high specific resistance. Therefore, it becomes possible to reduce the distance $L_p$ between the p type base layers 23 without increasing the resistance $R_j$ due to the JFET effect, so that the MOS unit cell density per unit area can be increased. Thus, the resistance $R_{ch}$ of channel regions 25 as well as the resistance $R_j$, which are factors of the ON resistance $R_{on}$, can be reduced to the extent of approximately 35 to 40 percent of those in a conventional device. As a result, the ON resistance of this device can be further lowered in comparison with the device of the first construction shown in Fig. 2.

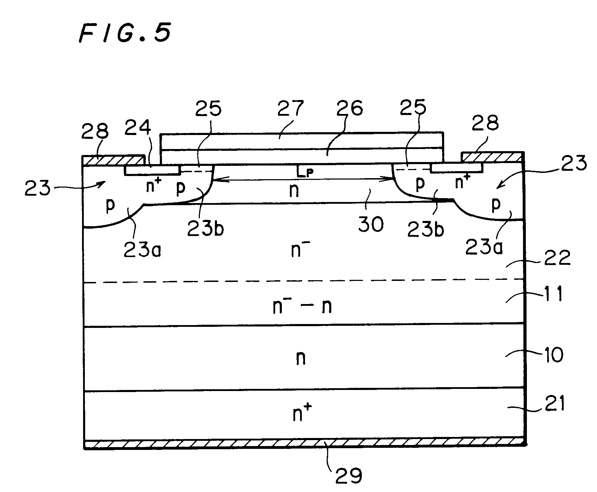

Fig. 5 is a cross-sectional view showing an embodiment of the power MOS field effect transistor according to the present invention, wherein an n type semiconductor layer 30, similar to that in the third construction shown in Fig. 4, is provided between the p type base layers 23. Other structures are the same as those in the second construction shown in Fig. 3. The details of this embodiment will be clear from the above description of the second and third constructions, and hence are omitted here in order to avoid unnecessary repetitions.

In the above constructions and the embodiment, the electric field of a depletion layer, which extends from the p type base layers 23 into the $n^-$ type epitaxial layer 22 upon application of a high voltage across the source and drain electrodes 28 and 29, is eased by virtue of the gentle inclination of the impurity concentration distribution between the $n^+$ type substrate 21 and the $n^-$ type epitaxial layer 22. Thus, the breakdown voltage is not decreased in spite of a decrease of the thickness of the $n^-$ type epitaxial layer 22. As a result, a power MOS field effect transistor having both a relatively low ON resistance and a relatively high breakdown voltage can be implemented.

Although power MOS field effect transistors, which have a breakdown voltage of 500 V, have been described in detail, the same effects can be attained with respect to a field effect transistor which has greater breakdown voltage than 500 V, by appropriately designing the specific resistances and the thicknesses of the $n^-$ type epitaxial layer 22 and the n type buffer layer 10, the thickness of the spreading layers 11 and 12 and the like, in accordance with a desired breakdown voltage. Further, although n channel type field effect transistors have been described in the above, the invention is also applicable to a p channel type field effect transistor, as a matter of course.

## Claims

1. A field effect transistor, comprising:
   - a first conductivity type semiconductor substrate (21) of a relatively high first impurity concentration, having first and second major surfaces;
   - a first conductivity type intermediate semiconductor layer (11, 12) which is formed above the first major surface of the semiconductor substrate (21);
   - a first conductivity type first semiconductor layer (22) of a relatively low second impurity concentration, formed on the intermediate semiconductor layer (11, 12),

- a second conductivity type base layer (23) formed in a surface of the first semiconductor layer (22) and comprising two spaced base regions separated by the first semiconductor layer (22);
- a first conductivity type source layer (24) formed in a surface of each of the base regions (23) thus forming two source regions;
- a gate insulation film (26) formed on a surface part of the source regions (24), the first semiconductor layer (22) and the base regions (23);
- a gate electrode (27) formed on the gate insulation film (26);
- source electrodes (28) formed on and electrically connected with each of the base regions (23) and the source regions (24), respectively; and
- a drain electrode (29) formed on and electrically connected to the second major surface of the semiconductor substrate (21),

characterized in that the base layer (23) comprises a first deep base layer (23a) and a second shallow base layer (23b) formed in the surface of the first semiconductor layer (22),

in that a first conductivity type second semiconductor layer (30) of a relatively low specific resistance is formed in a surface part of the first semiconductor layer (22) between the two base regions (23a, 23b), and in that the intermediate layer (11, 12) and the first semiconductor layer (22) have substantially the same thickness,

in that a first conductivity type buffer layer (10) is formed on the first major surface of the semiconductor substrate (21) between the semiconductor substrate (21) and the intermediate semiconductor layer (11) and has a third impurity concentration which is in the middle between the first and the second impurity concentrations,

and in that the intermediate semiconductor layer (11) has an impurity concentration which gently decreases from the third impuritiy concentration to the second impurity concentration, such that a portion of the intermediate semiconductor layer (11) near the buffer layer (10) has a relatively high impurity concentration while a portion of the intermediate semiconductor layer (11) near the first semiconductor layer (22) has a relatively low impurity concentration.

2.  A method for manufacturing a field effect transistor according to claim 1, comprising the following steps:
   - preparing a first conductivity type semiconductor substrate (21) of a relatively high first impurity concentration, having first and second major surfaces, wherein impurities in the semiconductor substrate (21) have a relatively low diffusion coefficient;
   - forming a first conductivity type intermediate semiconductor layer (11, 12) above the first major surface of the semiconductor substrate (21);
   - forming first conductivity type buffer layer (10) on the first major surface of the semiconductor substrate (21);
   - forming a first conductivity type first semiconductor layer (22) of a relatively low second impurity concentration on the buffer layer (10),
     wherein the buffer layer (10) has a third impurity concentration which is in the middle of the first and second impurity concentrations, wherein impurities in the buffer layer (10) have a relatively high diffusion coefficient;
   - spreading the buffer layer (10) into the first semiconductor layer (22) by heat treatment in order to form said first conductivity type intermediate semiconductor layer (11) between the buffer layer (10) and the first semiconductor layer (22), wherein the intermediate semiconductor layer (11) has an impurity concentration which gently decreases from the third impurity concentration to the second impurity concentration, such that a portion of the intermediaate semicoductor layer (11) near the buffer layer (10) has a relatively high impurity concentration while a portion of the intermediate semiconductor layer (11) near the first semiconductor layer (22) has a relatively low impurity concentration;
   - forming a second conductivity type base layer (23) including a first deep base layer (23a) and a second shallow base layer (23b) in a surface of the first semiconductor layer (22), the base layer (23) comprising two spaced base regions separated by the first semiconductor layer (22);
   - forming a first conductivity type source layer (24) in a surface of each of the base regions (23) thus forming two source regions;
   - forming a first conductivity type second semiconductor layer (30) of a relatively low specific resistance in a surface part of the first semiconductor layer (22) between the two base regions (23a, 23b);
   - forming a gate insulation film (26) on a surface part of the source regions (24), the first semiconductor layer (22) and the base regions (23);
   - forming a gate electrode (27) on the gate insulation film (26);
   - forming source electrodes (28) on each of the base regions (23) and the source regions (24), respectively; and
- forming a drain electrode (29) on the second major surface of the semiconductor substrate (21).

## Patentansprüche

1. Feldeffekttransistor, umfassend:
   - ein Halbleitersubstrat (21) von einem ersten Leitungstyp mit einer relativ hohen, ersten Verunreinigungskonzentration, das eine erste und eine zweite Hauptfläche aufweist;
   - eine Halbleiterzwischenschicht (11, 12) von dem ersten Leitungstyp, die über der ersten Hauptfläche des Halbleitersubstrats (21) ausgebildet ist;
   - eine erste Halbleiterschicht (22) von dem ersten Leitungstyp mit einer relativ geringen, zweiten Verunreinigungskonzentration, die auf der Halbleiterzwischen schicht (11, 12) ausgebildet ist;
   - eine Basis-Schicht (23) von einem zweiten Leitungstyp, die in einer Fläche der ersten Halbleiterschicht (22) ausgebildet ist und zwei beabstandete Basis-Bereiche aufweist, die durch die erste Halbleiterschicht (22) getrennt sind;
   - eine Source-Schicht (24) von dem ersten Leitungstyp, die in einer Hauptfläche der beiden BasisBereiche (23) ausgebildet ist, so daß zwei Source-Bereiche gebildet werden;
   - eine Gate-Isolierschicht (26), die auf einem Teil der Oberfläche der Source-Bereiche (24), der ersten Halbleiterschicht (22) und den Basis-Bereichen (23) ausgebildet ist;
   - eine Gate-Elektrode (27), die auf der Gate-Isolierschicht (26) ausgebildet ist;
   - Source-Elektroden (28), die auf jedem der BasisBereiche (23) und der Source-Bereiche (24) ausgebildet und mit diesen elektrisch verbunden sind; und
   - eine Drain-Elektrode (29), die auf der zweiten Hauptfläche des Halbleitersubstrats (21) ausgebildet und mit dieser elektrisch verbunden ist,

   dadurch gekennzeichnet,
   daß die Basis-Schicht (23) eine erste tiefe Basis-Schicht (23a) und eine zweite flache Basis-Schicht (23b) aufweist, die in der Oberfläche der ersten Halbleiterschicht (22) ausgebildet ist,
   daß eine zweite Halbleiterschicht (30) von dem ersten Leitungstyp mit einem relativ geringen spezifischen Widerstand in einem Teil der Oberfläche der ersten Halbleiterschicht (22) zwischen den beiden Basis-Bereichen (23a, 23b) ausgebildet ist,
   daß die Zwischenschicht (11, 12) und die erste Halbleiterschicht (22) im wesentlichen die gleiche Dicke aufweisen,
   daß eine Pufferschicht (10) von dem ersten Leitungstyp auf der ersten Hauptfläche des Halbleitersubstrats (21) zwischen dem Halbleitersubstrat (21) und der Halbleiterzwischenschicht (11) ausgebildet ist und eine dritte Verunreinigungskonzentration aufweist, die in der Mitte zwischen der ersten und der zweiten Verunreinigungskonzentration liegt,
   und daß die Halbleiterzwischenschicht (11) eine Verunreinigungskonzentration aufweist, die sanft von der dritten Verunreinigungskonzentration auf die zweite Verunreinigungskonzentration abnimmt, derart, daß ein Teil der Halbleiterzwischenschicht (11) in der Nähe der Pufferschicht (10) eine relativ hohe Verunreinigungskonzentration aufweist, während ein Teil der Halbleiterzwischenschicht (11) in der Nähe der ersten Halbleiterschicht (22) eine relativ geringe Verunreinigungskonzentration aufweist.

2. Verfahren zur Herstellung eines Feldeffekttransistors gemäß Anspruch 1, umfassend die folgenden Schritte:
   - Herstellen eines Halbleitersubstrats (21) von einem ersten Leitungstyp und mit einer relativ hohen, ersten Verunreinigungskonzentration, das erste und zweite Hauptflächen aufweist, wobei Verunreinigungen in dem Halbleitersubstrat (21) einen relativ niedrigen Diffusionskoeffizienten aufweisen;
   - Ausbilden einer Halbleiterzwischenschicht von dem ersten Leitungstyp (11, 12) über der ersten Hauptfläche des Halbleitersubstrats (21);
   - Ausbilden einer Pufferschicht (10) von dem ersten Leitungstyp auf der ersten Hauptfläche des Halbleitersubstrats (21);
   - Ausbilden einer ersten Halbleiterschicht (22) von dem ersten Leitungstyp mit einer relativ geringen zweiten Verunreinigungskonzentration auf der Pufferschicht (10), wobei die Pufferschicht (10) eine dritte Verunreinigungskonzentration aufweist, die in der Mitte zwischen der ersten und der zweiten Verunreinigungskonzentration liegt, wobei die Verunreinigungen in der Pufferschicht (10) einen relativ hohen Diffusionskoeffizienten aufweisen;
   - Ausdehnen der Pufferschicht (10) in die erste Halbleiterschicht (22) hinein durch Wärmebehandlung,

7

um die Halbleiterzwischenschicht (11) von dem ersten Leitungstyp zwischen der Pufferschicht (10) und der ersten Halbleiterschicht (22) auszubilden, wobei die Halbleiterzwischenschicht (11) eine Verunreinigungskonzentration aufweist, die sanft von der dritten Verunreinigungskonzentration auf die zweite Verunreinigungskonzentration abnimmt, derart, daß ein Teil der Halbleiterzwischenschicht (11) in der Nähe der Pufferschicht (10) eine relativ hohe Verunreinigungskonzentration aufweist, während ein Teil der Halbleiterzwischenschicht (11) in der Nähe der ersten Halbleiterschicht (22) eine relativ geringe Verunreinigungskonzentration aufweist;

- Ausbilden einer BasisSchicht (23) von einem zweiten Leitungstyp, die eine erste tiefe Basis-Schicht (23a) und eine zweite flache Basis-Schicht (23b) in einer Oberfläche der ersten Halbleiterschicht (22) enthält, wobei die Basis-Schicht (23) zwei beabstandete Basis-Bereiche aufweist, die durch die erste Halbleiterschicht (22) getrennt sind;
- Ausbilden einer Source-Schicht (24) von dem ersten Leitungstyp in einer Oberfläche der beiden Basis-Bereiche (23), so daß zwei Source-Bereiche gebildet werden;
- Ausbilden einer zweiten Halbleiterschicht (30) von dem ersten Leitungstyp mit einem relativ geringen spezifischen Widerstand in einem Teil der Oberfläche der ersten Halbleiterschicht (22) zwischen den beiden Basis-Bereichen (23a, 23b);
- Ausbilden einer Gate-Isolierschicht (26) auf einem Teil der Oberfläche der Source-Bereiche (24), der ersten Halbleiterschicht (22) und den BasisBereichen (23);
- Ausbilden einer Gate-Elektrode (27) auf der Gate-Isolierschicht (26);
- Ausbilden von Source-Elektroden (28) auf jedem von den beiden Basis-Bereichen (23) bzw. den Source-Bereichen (24); und
- Ausbilden einer Drain-Elektrode (29) auf der zweiten Hauptfläche des Halbleitersubstrats (21).

## Revendications

1. Transistor à effet de champ, comprenant :
   - un substrat semi-conducteur (21) d'un premier type de conductivité et présentant une première concentration en impuretés relativement élevée, ledit substrat ayant une première et une seconde surface principale ;
   - une couche semi-conductrice intermédiaire (11, 12) du premier type de conductivité, qui est formée au-dessus de la première surface principale du substrat semi-conducteur (21);
   - une première couche semi-conductrice (22) du premier type de conductivité et présentant une seconde concentration en impuretés relativement faible, formée sur la couche semiconductrice intermédiaire (11, 12) ;
   - une couche de base (23) d'un second type de conductivité et formée dans une surface de la première couche semiconductrice (22) et comprenant deux régions de base espacées séparées par la première couche semi-conductrice (22) ;
   - une couche de source (24) du premier type de conductivité et formée dans une surface de chacune des régions de base (23) en formant ainsi deux régions source ;
   - un film (26) d'isolement de grille formé sur une partie de la surface des régions de source (24), la première couche semi-conductrice (22) et les régions de base (23) ;
   - une électrode de grille (27) formée sur le film d'isolement de grille (26) ;
   - des électrodes de source (28) formées sur chacune des régions de base (23) et des régions de source (24) respectivement, et électriquement connectées à ces régions ; et
   - une électrode de drain (29) formée sur la seconde surface principale du substrat semi-conducteur (21) et électriquement connectée à cette surface ;
   caractérisé en ce que la couche de base (23) comprend une première couche de base profonde (23a) et une seconde couche de base mince (23b) formées dans la surface de la première couche semi-conductrice (22),
   en ce qu'une seconde couche semi-conductrice (30) du premier type de conductivité et présentant une résistance spécifique relativement basse est formée dans une partie de la surface de la première couche semi-conductrice (22) entre les deux régions de base (23a, 23b),
   en ce que la couche intermédiaire (11, 12) et la première couche semi-conductrice (22) ont sensiblement la même épaisseur,
   en ce qu'une première couche tampon (10) du premier type de conductivité est formée sur la première surface principale du substrat semi-conducteur (21) entre le substrat semiconducteur (21) et la couche semi-conductrice intermédiaire (11) et possède une troisième concentration en impuretés qui est au milieu entre la première et la seconde concentration en impuretés,

et en ce que la couche semi-conductrice intermédiaire (11) présente une concentration en impuretés qui décroît progressivement depuis la troisième concentration en impuretés vers la seconde concentration en impuretés, de sorte qu'une partie de la couche semi-conductrice intermédiaire (11) proche de la couche tampon (10) présente une concentration en impuretés relativement élevée, tandis qu'une partie de la couche semi-conductrice intermédiaire (11) proche de la première couche semi-conductrice (22) présente une concentration en impuretés relativement basse.

2. Procédé de fabrication d'un transistor à effet de champ selon la revendication 1, comprenant les étapes suivantes :

- on prépare un substrat semi-conducteur (21) d'un premier type de conductivité et présentant une première concentration en impuretés relativement élevée, possédant une première et une seconde surface principale, les impuretés dans le substrat semi-conducteur (21) présentant un coefficient de diffusion relativement faible ;
- on forme une couche semi-conductrice intermédiaire (11, 12) du premier type de conductivité au-dessus de la première surface principale du substrat semi-conducteur (21) ;
- on forme une couche tampon (10) du premier type de conductivité sur la première surface principale du substrat semi-conducteur (21) ;
- on forme une première couche semi-conductrice (22) du premier type de conductivité et présentant une seconde concentration en impuretés relativement faible sur la couche tampon (10) ; ladite couche tampon (10) présentant une troisième concentration en impuretés qui est au milieu entre la première et la seconde concentration en impuretés, et les impuretés dans la couche tampon (10) présentant un coefficient de diffusion relativement élevé ;
- on fait diffuser la couche tampon (10) dans la première couche semi-conductrice (22) par traitement thermique afin de former ladite couche semi-conductrice intermédiaire (11) du premier type de conductivité entre la couche tampon (10) et la première couche semi-conductrice (22), la couche semi-conductrice intermédiaire (11) présentant une concentration en impuretés qui diminue progressivement depuis la troisième concentration en impuretés jusqu'à la seconde concentration en impuretés de telle sorte qu'une partie de la couche semiconductrice intermédiaire (11) proche de la couche tampon (10) présente une concentration en impuretés relativement élevée tandis qu'une partie de la couche semi-conductrice intermédiaire (11) proche de la première couche semiconductrice (22) présente une concentration en impuretés relativement faible ;
- on forme une couche de base (23) d'un second type de conductivité, comprenant une première couche de base profonde (23a) et une seconde couche de base mince (23b) dans une surface de la première couche semi-conductrice (22), la couche de base (23) comprenant deux régions de base espacées séparées par la première couche semi-conductrice (22) ;
- on forme une couche de source (24) du premier type de conductivité dans une surface de chacune des régions de base (23) formant ainsi deux régions source ;
- on forme une seconde couche semi-conductrice (30) du premier type de conductivité et présentant une résistance spécifique relativement basse, dans une partie de la surface de la première couche semi-conductrice (22) entre les deux régions de base (23a, 23b) ;
- on forme un film d'isolement de grille (26) sur une partie de la surface des régions de source (24), la première couche semi-conductrice (22), et les régions de base (23) ;
- on forme une électrode de grille (27) sur le film d'isolement de grille (26) ;
- on forme des électrodes de source (28) sur chacune des régions de base (23) et des régions de source (24) respectivement ; et
- on forme une électrode de drain (29) sur la seconde surface principale du substrat semi-conducteur (21).

FIG. 1

FIG. 2

*FIG.3*

*FIG.4*

# *F I G . 5*